# EUROPEAN PATENT APPLICATION

(11) **EP 2 043 133 A1**
(43) Date of publication of application: **01.04.2009**
(21) Application number: 07744931.2
(22) Date of filing: 08.06.2007
(51) Int. Cl.: H01L 21/027, G03F 7/20

(54) **EXPOSING METHOD, EXPOSING DEVICE, AND DEVICE MANUFACTURING METHOD**

(30) Priority: 30.06.2006 JP 2006180623
(71) Applicant: Nikon Corporation, Tokyo 100-8331 (JP)
(72) Inventor: NISHINAGA, Hisashi, Tokyo 100-8331 (JP)
(74) Representative: Hooiveld, Arjen Jan Winfried
(86) International application number: PCT/JP2007/061611
(87) International publication number: WO 2008/001593

(57) **Abstract**

An exposure method is arranged to guide illumination light having passed through a first pattern formed in a first pattern formation region and a second pattern formed in a second pattern formation region different from the first pattern formation region, to a substrate to transfer the first pattern and the second pattern onto the substrate. The exposure method comprises a first-illumination-forming-member preparing step (S10) of preparing a first illumination forming member for forming illumination light according to an illumination condition for illuminating the first pattern; a second-illumination-forming-member preparing step (S11) of preparing a second illumination forming member for forming illumination light according to an illumination condition for illuminating the second pattern; a pattern scanning step of scanning the first pattern and the second pattern, and the substrate in a scanning direction with respect to the illumination light; an illumination-forming-member scanning step of scanning the first illumination forming member and the second illumination forming member in synchronism with the first pattern and the second pattern; and an exposure step (S 13) of effecting an exposure of the first pattern in a first pattern transfer region on the substrate and effecting an exposure of the second pattern in a second pattern transfer region on the substrate. The exposure step includes consecutively carrying out the exposure of the first pattern and the exposure of the second pattern.

## Description

### Technical Field

The present invention relates to an exposure method used in a lithography process for manufacturing semiconductor devices, liquid-crystal display devices, thin-film magnetic heads, etc., an exposure apparatus using the exposure method, and a device manufacturing method using the exposure method or the exposure apparatus.

### Background Art

The lithography process for manufacturing such devices as the semiconductor devices, liquid-crystal display devices, and thin-film magnetic heads is carried out using an exposure apparatus for transferring an image of a pattern formed on a mask, onto a substrate coated with a photosensitive agent. One of exposure methods using this exposure apparatus is to use a double exposure method carried out as follows: for transferring a pattern as a mixture of a first pattern (e.g., a cyclic pattern) and a second pattern (e.g., an isolated pattern), into one exposure region on a wafer to effect exposures thereof, a first mask with the first pattern thereon and a second mask with the second pattern thereon are prepared and the patterns are sequentially transferred to effect exposures thereof under optimal exposure conditions (illumination conditions) according to the respective patterns.

For effecting the exposure by the double exposure method, it is common practice to first effect the first exposure with the first mask, then replace the first mask with the second mask, and thereafter effect the second exposure with the second mask. However, this method requires a certain time for replacement of the mask and thus failed to achieve a high throughput. Therefore, the following double exposure method was proposed: the first pattern and the second pattern are formed on one mask; the first pattern is transferred into a first shot area (exposure region) and the second pattern is transferred into a second shot area on a wafer by a scanning exposure method; the wafer is then stepped by a length of one shot area in a scanning direction; the first pattern and the second pattern are then transferred into the second shot area and into a third shot area, respectively; this operation is serially repeated to effect double exposure with the first pattern and the second pattern (e.g., cf. Japanese Patent Application Laid-open No. 11-111601).

### Disclosure of the Invention

Incidentally, the exposure apparatus described in Patent Document 1 needs to perform the exposures under the optimal illumination conditions according to the respective patterns during the scanning exposure with the patterns. Namely, the exposure apparatus first performs the scanning exposure with the first pattern under the optimal illumination condition according to the first pattern, then switches the illumination condition to the optimal illumination condition according to the second pattern, and thereafter performs the scanning exposure with the second pattern. However, an illumination optical system of the exposure apparatus requires a certain time for switching the illumination condition to the optimal illumination condition according to each pattern, which caused a reduction in throughput.

An object of the present invention is to provide an exposure method capable of consecutively effecting exposures of a plurality of patterns on a substrate with desired illumination light beams corresponding to the respective patterns, without reduction in throughput, an exposure apparatus using the exposure method, and a device manufacturing method using the exposure method or the exposure apparatus.

An exposure method of the present invention is an exposure method for guiding illumination light having passed through a first pattern formed in a first pattern formation region and a second pattern formed in a second pattern formation region different from the first pattern formation region, to a substrate to transfer the first pattern and the second pattern onto the substrate, the exposure method comprising: a first-illumination-forming-member preparing step of preparing a first illumination forming member for forming illumination light according to an illumination condition for illuminating the first pattern; a second-illumination-forming-member preparing step of preparing a second illumination forming member for forming illumination light according to an illumination condition for illuminating the second pattern; a pattern scanning step of scanning the first pattern and the second pattern, and the substrate in a scanning direction with respect to the illumination light; an illumination-forming-member scanning step of scanning the first illumination forming member and the second illumination forming member in synchronism with the first pattern and the second pattern; and an exposure step of effecting an exposure of the first pattern in a first pattern transfer region on the substrate and effecting an exposure of the second pattern in a second pattern transfer region on the substrate; wherein the exposure step comprises consecutively carrying out the exposure of the first pattern and the exposure of the second pattern.

An exposure apparatus of the present invention is an exposure apparatus for guiding illumination light having passed through a first pattern formed in a first pattern formation region and a second pattern formed in a second pattern formation region different from the first pattern formation region, to a substrate to transfer the first pattern and the second pattern onto the substrate, the exposure apparatus comprising: a first illumination forming member arranged in an optical path of the illumination light traveling toward the first pattern and for forming the illumination light according to an illumination condition for illuminating the first pattern; and a second illumination forming member arranged in an optical path of the illumination light traveling toward the second pattern and for forming the illumination light according to an illumination condition for illuminating the second pattern; wherein the first pattern and the second pattern, and the substrate are scanned in a scanning direction with respect to the illumination light to consecutively transfer the first pattern and the second pattern onto the substrate to effect exposures thereof, and wherein the first illumination forming member and the second illumination forming member are scanned in synchronism with the first pattern and the second pattern.

A device manufacturing method of the present invention is a method comprising an exposure step of effecting an exposure of a predetermined pattern on a substrate, using an exposure apparatus for performing the exposure by the exposure method of the present invention, or using the exposure apparatus of the present invention; and a development step of developing the substrate exposed in the exposure step.

Another device manufacturing method of the present invention is a method comprising an exposure step of effecting exposures of a first pattern and a second pattern in a superimposed state on a substrate, using an exposure apparatus for performing the exposures by the exposure method of the present invention, or using the exposure apparatus of the present invention; and a development step of developing the substrate exposed in the exposure step.

An illumination angle distribution changing member of the present invention is an illumination angle distribution changing member which can be arranged near a photomask on which a pattern to be transferred onto a substrate is formed, and which changes an angle distribution of illumination light traveling toward the photomask, the illumination angle distribution changing member comprising a polarizing member for setting a polarization state of the illumination light traveling toward the photomask, to a predetermined polarization state.

### Brief Description of the Drawings

Fig. 1 is a drawing showing a configuration of an exposure apparatus according to the first embodiment.
Fig. 2 is a drawing showing a configuration of an exposure apparatus according to the second embodiment.
Fig. 3 is a drawing showing a shape of an illumination field formed on an entrance surface of a microlens array.
Fig. 4 is a drawing showing a shape of illumination light on a pupil plane of a projection optical system.
Fig. 5 is a drawing showing a shape of illumination light on the pupil plane of the projection optical system.
Fig. 6 is a drawing showing another configuration of a reticle.
Fig. 7 is a drawing showing another configuration of an illumination forming member.
Fig. 8 is a flowchart for explaining an exposure method according to an embodiment.
Fig. 9 is a flowchart showing a method of manufacturing semiconductor devices as micro devices according an embodiment of the present invention.
Fig. 10 is a flowchart showing a method of manufacturing a liquid-crystal display device as a micro device according to an embodiment of the present invention.

### Best Mode for Carrying out the Invention

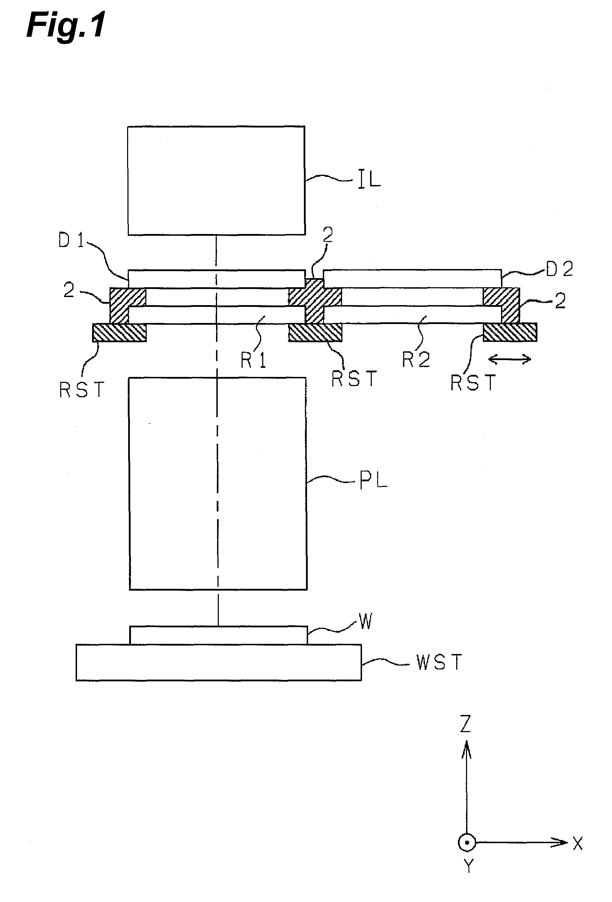

The exposure apparatus according to the first embodiment of the present invention will be described below with reference to the drawing. Fig. 1 is a drawing showing a configuration of the exposure apparatus according to the first embodiment. The exposure apparatus shown in Fig. 1 is a projection exposure apparatus for performing double exposures by the step-and-scan method. In the description hereinafter, an XYZ orthogonal coordinate system is set as shown in Fig. 1 and positional relations among members will be described with reference to this XYZ orthogonal coordinate system. The XYZ orthogonal coordinate system is so defined that the X-axis and the Y-axis are set in parallel with a wafer W and that the Z-axis is set in a direction perpendicular to the wafer W. In this embodiment the X-axis direction is set along a direction of movement of the wafer W (scanning direction).

As shown in Fig. 1, the exposure apparatus of the first embodiment includes, for example, an ArF excimer laser light source for supplying light with the wavelength of about 193 nm or a KrF excimer laser light source for supplying light with the wavelength of about 248 nm as an exposure light source (not shown), and is provided with an illumination optical system IL composed of a relay optical system, an optical integrator, a field stop, a condenser optical system, etc. not shown. Illumination light emitted from the light source travels through the illumination optical system IL, and then through a first illumination shape forming member D1 or a second illumination shape forming member D2 for diffracting the illumination light incident thereto, to illuminate a reticle R1 (first pattern formation region) or a reticle R2 (second pattern formation region).

The first illumination shape forming member D1 is disposed in the optical path of the illumination light traveling toward the reticle R1 and forms illumination light according to an illumination condition suitable for illumination of the first pattern, based on characteristics (fineness, orientation, etc.) and others of the first pattern formed on the reticle R1. Namely, the first illumination shape forming member D1 has a diffractive grating pattern formed to diffract the illumination light so that an angle distribution of the illumination light traveling toward the first pattern formed on the reticle R1, becomes a desired angle distribution, i.e., an optimal angle distribution (first angle distribution) for illumination of the first pattern, in order to illuminate the first pattern with optimal illumination light.

The second illumination shape forming member D2 is disposed in the optical path of the illumination light traveling toward the reticle R2 and forms illumination light according to an illumination condition suitable for illumination of the second pattern, based on characteristics (fineness, orientation, etc.) and others of the second pattern formed on the reticle R2. Namely, the second illumination shape forming member D2 has a diffractive grating pattern formed to diffract the illumination light so that an angle distribution of the illumination light traveling toward the second pattern formed on the reticle R2, becomes a desired angle distribution, i.e., an optimal angle distribution (second angle distribution) for illumination of the second pattern, in order to illuminate the second pattern with optimal illumination light.

The reticle R1 and the reticle R2 are mounted so as to be approximately adjacent to each other along the X-direction (scanning direction) on a reticle stage (original plate stage) RST. The reticle stage RST is arranged to be movable along the X-direction, fmely movable along the Y-direction, and fmely rotatable around the Z-direction in the XY plane. The first illumination shape forming member D1 and the second illumination shape forming member D2 are arranged approximately adjacent to each other along the X-direction (scanning direction) and are held by a holding member 2. The holding member 2 is mounted on the reticle stage RST so that the first illumination shape forming member D1 and the second illumination shape forming member D2 are located above the reticle R1 and above the reticle R2, respectively.

The illumination light having passed through the first illumination shape forming member D1 or the second illumination shape forming member D2 has an angle distribution given by the first illumination shape forming member D1 or the second illumination shape forming member D2, to superposedly illuminate the reticle R1 or the reticle R2.

The illumination light having passed through the first pattern or the second pattern formed on the reticle R1 or the reticle R2, travels through a projection optical system PL to illuminate the wafer (substrate) W being a photosensitive substrate. After the illumination light passes through the first illumination shape forming member D1 or the second illumination shape forming member D2, the illumination light has, for example, an annular shape, a dipolar shape, a quadrupolar shape, or the like on the pupil plane of the projection optical system PL. The wafer W is mounted on a wafer stage WST. The wafer stage WST is arranged to be movable along the X-direction and the Y-direction and rotatable around the Z-direction in the XY plane.

When this exposure apparatus is used to transfer the first pattern and the second pattern onto the wafer W to effect exposures thereof, the reticle stage RST and the wafer stage WST are scanned in the scanning direction (X-direction) with respect to the illumination light to transfer the first pattern into a first shot area (first pattern transfer region) on the wafer W and transfer the second pattern into a second shot area (second pattern transfer region) on the wafer W to effect exposures thereof. Namely, the first pattern and the second pattern are consecutively transferred onto the wafer W to effect exposures thereof. Since at this time the first illumination shape forming member D1 and the second illumination shape forming member D2 are scanned in synchronism with the reticle R1 and the reticle R2, the first pattern is transferred to effect the exposure thereof with the illumination light having passed through the first illumination shape forming member D 1 and the second pattern is transferred to effect the exposure thereof with the illumination light having passed through the second illumination shape forming member D2. Namely, since the illumination is instantly switched to the illumination light according to the illumination condition suitable for each pattern, high imaging performance is achieved and the transfer exposure process is carried out without reduction in throughput.

Then the wafer stage WST is moved by a length of one shot area in the scanning direction, the first pattern is transferred into the second shot area on the wafer W to effect an exposure thereof, and the second pattern is transferred into a third shot area on the wafer W to effect an exposure thereof. Namely, the exposures of the first pattern and the second pattern are effected in a superimposed state in the second shot area. By repeating such transfer exposures of the first pattern and the second pattern, exposures of the first pattern and the second pattern are effected in a superimposed state in each shot area.

Since this exposure apparatus of the first embodiment is arranged to scan the first illumination forming member D1 and the second illumination forming member D2 in synchronism with the reticle R1 and the reticle R2, it is able to perform the exposure of the first pattern formed on the reticle R1, in the first shot area on the wafer W with the desired illumination light made by the first illumination forming member D1 and to consecutively effect the transfer exposure of the second pattern formed on the reticle R2, in the second shot area on the wafer W with the desired illumination light made by the second illumination forming member D2. Since the first pattern and the second pattern are thus illuminated with the illumination light beams optimal for the respective patterns, high imaging performance is achieved in each of the first pattern and the second pattern and the illumination light is instantly switched from the illumination light suitable for the first pattern to the illumination light suitable for the second pattern; therefore, the throughput is improved.

The exposure apparatus of the first embodiment is constructed using the diffractive optical elements with the respective diffractive grating patterns as the first illumination forming member D1 and the second illumination forming member D2, but the exposure apparatus may also be constructed using refracting optical elements capable of making an angle distribution of the illumination light traveling toward either of the reticle R1 and the reticle R2, into a desired angle distribution.

The exposure apparatus of the first embodiment is constructed with the first illumination forming member D1 and the second illumination forming member D2 for forming the two illumination light beams corresponding to the two patterns, but the exposure apparatus may also be constructed with three or more illumination forming members for forming three or more illumination light beams corresponding to three or more patterns.

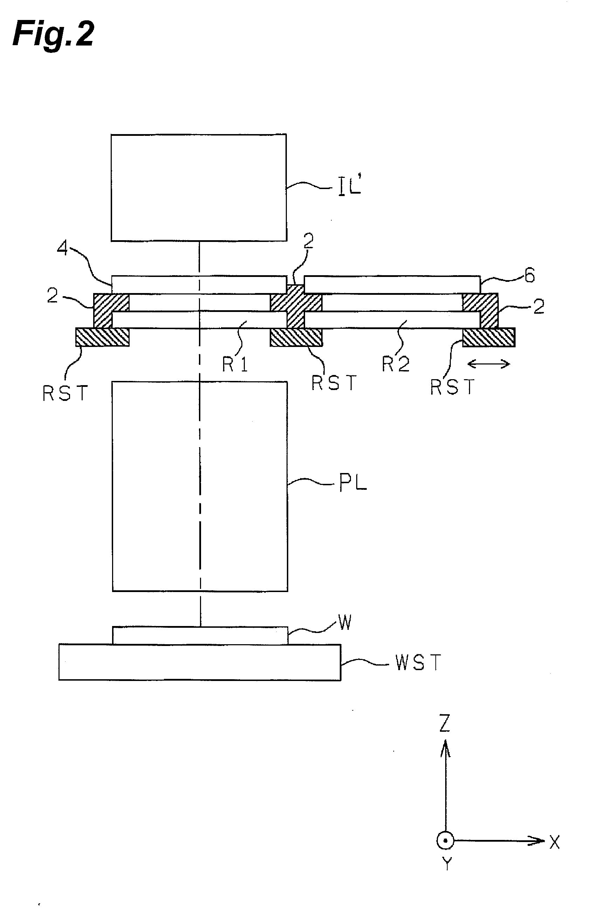

Next, the exposure apparatus according to the second embodiment of the present invention will be described with reference to the drawing. Fig. 2 is a drawing showing a configuration of the exposure apparatus according to the second embodiment. As shown in Fig. 2, the exposure apparatus of the second embodiment is one obtained by changing the illumination optical system IL of the exposure apparatus of the first embodiment into an illumination optical system IL', the first illumination shape forming member D1 into a first polarizing member 4, and the second illumination shape forming member D2 into a second polarizing member 6. In the description of the second embodiment, therefore, detailed description will be omitted for the same configuration as the configuration of the exposure apparatus of the first embodiment. In the description of the second embodiment, the same configuration as the configuration of the exposure apparatus of the first embodiment will be described using the same reference symbols as those in the first embodiment.

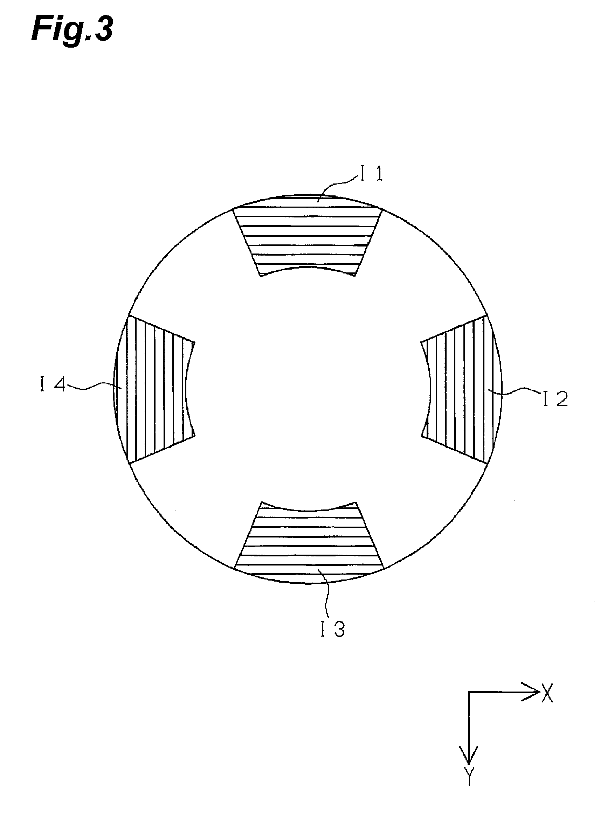

The illumination optical system IL' has an unrepresented laser light source. Linearly polarized light (illumination light) with the polarization direction along the X-direction emitted from the laser light source travels via an unrepresented relay optical system and others to enter a diffractive optical element (not shown). The diffractive optical element has a function to change the size and shape of the illumination light on the pupil plane of the illumination optical system IL'. In this embodiment, the diffractive optical element changes the shape of the illumination light on the pupil plane of the illumination optical system IL' into a quadrupolar shape having local illumination regions I1-I4 as shown in Fig. 3.

The illumination light exiting from the diffractive optical element travels via an unrepresented relay optical system and others to enter a polarization converting member (not shown). The polarization converting member has a function to change a polarization state of the illumination light to the wafer W (i.e., illumination light to the reticle R1 or the reticle R2). Specifically, the polarization converting member, for example, when linearly polarized light with the polarization direction along the X-direction is incident thereto, converts the incident linearly polarized light into linearly polarized light substantially parallel to a circumferential direction of a circle centered on the optical axis of the illumination optical system IL'. In this embodiment, the illumination light passing through the local illumination regions I1 and I3 appears as linearly polarized light with the polarization direction along the X-direction (which will be referred to hereinafter as first linearly polarized light), while the polarization direction is maintained along the X-direction without conversion. The illumination light passing through the local illumination regions I2 and I4 appears as linearly polarized light with the polarization direction along the Y-direction (which will be referred to hereinafter as second linearly polarized light), while the polarization direction is converted into the Y-direction.

The beam having passed through the polarization converting member travels through a microlens array (not shown) and others and then through the first polarizing member 4 or the second polarizing member 6 to illuminate the reticle R1 or the reticle R2. Concerning the detailed configuration and action of the illumination optical system IL' with the diffractive optical element, the polarization converting member, etc., reference can be made to Japanese Patent Application Laid-open No. 2005-166871. The disclosure in this Laid-open No. 2005-166871 is explicitly incorporated herein by reference in its entirety.

The first polarizing member 4 is disposed in the optical path of the illumination light traveling toward the reticle R1 and forms the illumination light according to the illumination condition suitable for illumination of the first pattern, based on characteristics (fineness, orientation, etc.) and others of the first pattern formed on the reticle R1. Namely, the first polarizing member 4 is composed of a polarizer or the like for making a polarization state distribution of the illumination light traveling toward the first pattern formed on the reticle R1, into a desired polarization state, i.e., an optimal polarization state distribution for illumination of the first pattern (first polarization state distribution), in order to illuminate the first pattern with the optimal illumination light. In this embodiment, the first polarizing member 4 is composed of the polarizer that transmits only the first linearly polarized light.

The second polarizing member 6 is disposed in the optical path of the illumination light traveling toward the reticle R2 and forms the illumination light according to the illumination condition suitable for illumination of the second pattern, based on characteristics (fineness, orientation, etc.) and others of the second pattern formed on the reticle R2. Namely, the second polarizing member 6 is composed of a polarizer or the like for converting a polarization state distribution of the illumination light traveling toward the second pattern formed on the reticle R2, into a desired polarization state, i.e., an optimal polarization state distribution for illumination of the second pattern (second polarization state distribution), in order to illuminate the second pattern with the optimal illumination light. In this embodiment, the second polarizing member 6 is composed of the polarizer that transmits only the second linearly polarized light.

The illumination light traveling through the first polarizing member 4 or the second polarizing member 6 turns into illumination light with a predetermined polarization state distribution by virtue of passage through the first polarizing member 4 or the second polarizing member 6, to superposedly illuminate the reticle R1 or the reticle R2.

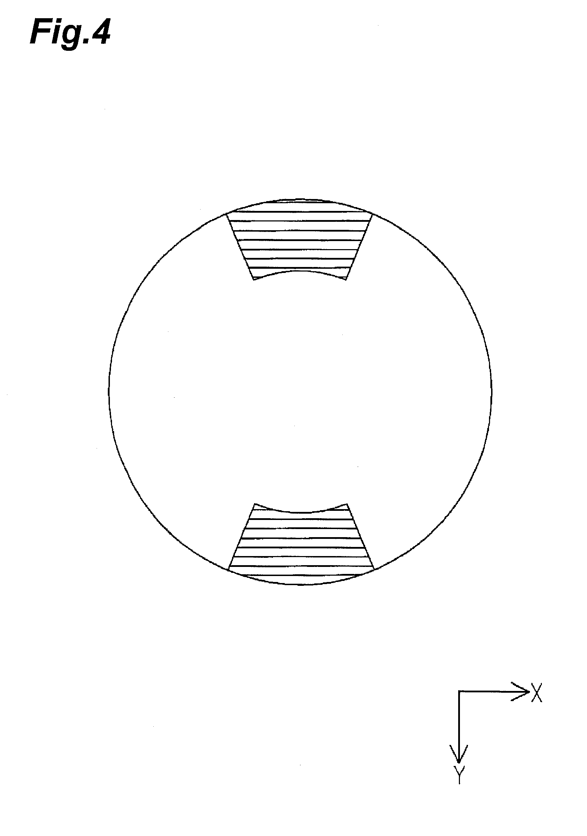

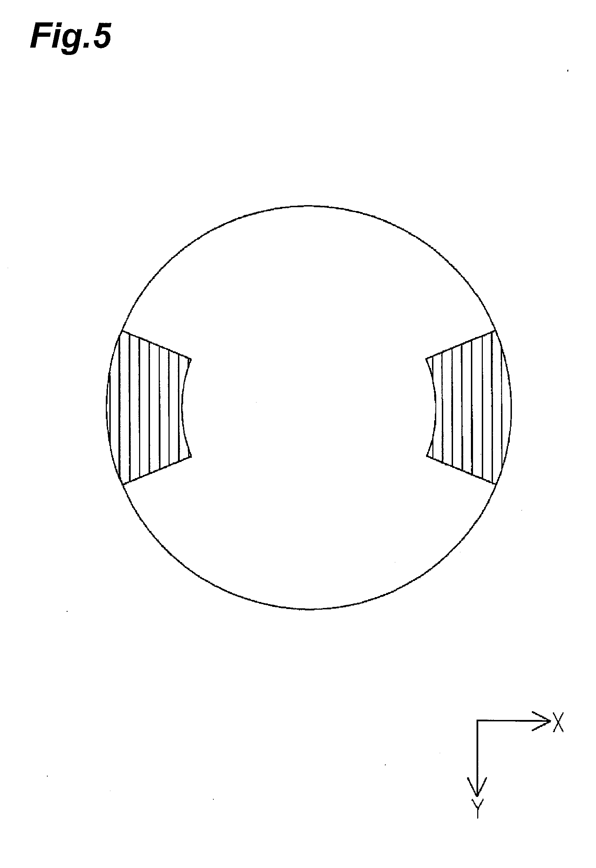

The illumination light transmitted by the first pattern or the second pattern formed on the reticle R1 or the reticle R2 travels through the projection optical system PL to illuminate the wafer (substrate) W being a photosensitive substrate. When the illumination light passes through the first polarizing member 4, only the first linearly polarized light is transmitted thereby and the shape of the illumination light on the pupil plane of the projection optical system PL is one as shown in Fig. 4. When the illumination light passes through the second polarizing member 6, only the second linearly polarized light is transmitted thereby and the shape of the illumination light on the pupil plane of the projection optical system PL is one as shown in Fig. 5.

When this exposure apparatus is used to transfer the first pattern and the second pattern onto the wafer W to effect exposures thereof, the reticle stage RST and the wafer stage WST are scanned in the scanning direction (X-direction) with respect to the illumination light, whereby the first pattern is transferred into a first shot area (first pattern transfer region) on the wafer W to effect an exposure thereof and the second pattern is transferred into a second shot area (second pattern transfer region) on the wafer W to effect an exposure thereof. Namely, the first pattern and the second pattern are consecutively transferred onto the wafer W to effect the exposures thereof. Since at this time the first polarizing member 4 and the second polarizing member 6 are scanned in synchronism with the reticle R1 and the reticle R2, the first pattern is transferred with the illumination light passing through the first polarizing member 4 and the second pattern is transferred with the illumination light passing through the second polarizing member 6, to effect the exposures thereof. Namely, since the illumination light is instantly switched to the illumination light according to the illumination condition suitable for each pattern, high imaging performance is achieved and the transfer exposure process is carried out without reduction in throughput.

Then the wafer stage WST is moved by a length of one shot area in the scanning direction, the first pattern is transferred into the second shot area on the wafer W to effect an exposure thereof, and the second pattern is transferred into a third shot area on the wafer W to effect an exposure thereof. By repeating such transfer exposures of the first pattern and the second pattern, exposures of the first pattern and the second pattern are effected in a superimposed state in each shot area.

Since the exposure apparatus of the second embodiment is arranged to scan the first polarizing member 4 and the second polarizing member 6 in synchronism with the reticle R1 and the reticle R2, it is able to perform the exposure of the first pattern formed on the reticle R1, in the first shot area on the wafer W with the illumination light having the desired polarization state distribution because of passage through the first polarizing member 4 and to consecutively effect the transfer exposure of the second pattern formed on the reticle R2, in the second shot area on the wafer W with the illumination light having the desired polarization state distribution because of passage through the second polarizing member 6. Since the first pattern and the second pattern are thus illuminated with the illumination light beams having their respective optimal polarization state distributions, high imaging performance is achieved in each of the first pattern and the second pattern and the illumination light is instantly switched from the illumination light beam suitable for the first pattern to the illumination light beam suitable for the second pattern; therefore, the throughput can be improved.

The exposure apparatus of the second embodiment is constructed with the first polarizing member 4 and the second polarizing member 6 for forming the illumination light beams with the two polarization state distributions corresponding to the two patterns, but the exposure apparatus may be constructed with three or more polarizing members for forming illumination light beams with three or more polarization state distributions corresponding to three or more patterns.

The exposure apparatus of the second embodiment is arranged to implement the quadrupolar illumination by the diffractive optical element of the illumination optical system IL', but the exposure apparatus may also be arranged to implement dipolar illumination, annular illumination, or the like.

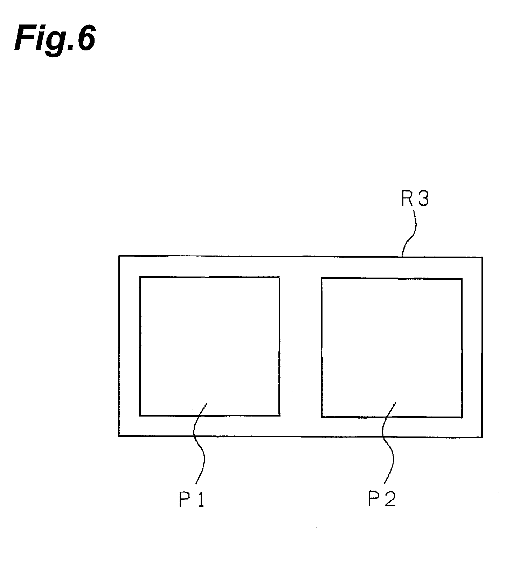

The exposure apparatus of each of the above-described embodiments is constructed with the reticle stage RST for holding the reticle R1 (first original plate) on which the first pattern is formed and the reticle R2 (second original plate) different from the reticle R1, on which the second pattern is formed, but the exposure apparatus may also be constructed, for example, using one reticle (original plate) R3 on which the first pattern P1 and the second pattern P2 are formed, as shown in Fig. 6, and having a reticle stage for holding this reticle R3.

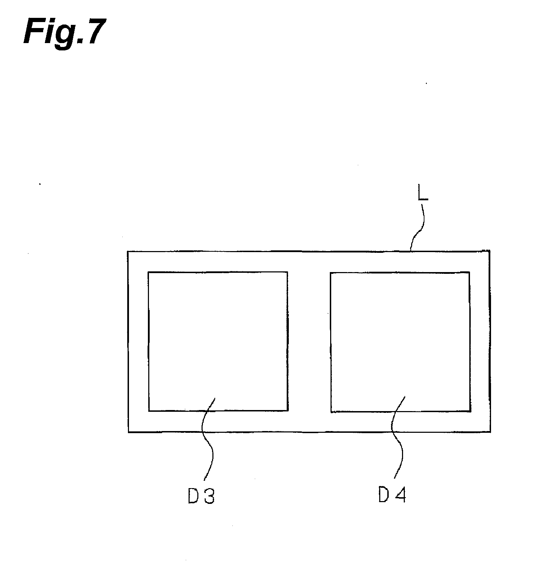

The exposure apparatus of each of the above-described embodiments is constructed with the holding member 2 for holding the first illumination shape forming member D1 and the second illumination shape forming member D2 or the first polarizing member 4 and the second polarizing member 6 as the first illumination forming member and the second illumination forming member, but the exposure apparatus may also be constructed, for example, using one optical member L with first illumination forming member D3 and second illumination forming member D4 as shown in Fig. 7 and having a holding member for holding this optical member L.

The exposure apparatus of each of the above-described embodiments is constructed so that the first illumination shape forming member D1 and second illumination shape forming member D2 or the first polarizing member 4 and second polarizing member 6 as the first illumination forming member and the second illumination forming member are located immediately above the reticles R1, R2, but the first illumination forming member and the second illumination forming member may also be located at or near the position of the field stop in the illumination optical system IL, i.e., at a position approximately optically conjugate with the reticles R1, R2. In this case, the first illumination forming member and the second illumination forming member are held by a holding member capable of scanning them in synchronism with the reticles R1, R2. In general, a reticle blind is located at a position approximately optically conjugate with the reticles R1, R2 and a reticle blind imaging optical system including the reticle blind includes a path folding mirror. In this case, therefore, the first illumination forming member and the second illumination forming member are moved in a direction different from the moving direction of the reticles R1, R2.

The exposure apparatus of each of the above-described embodiments is arranged so that the first illumination shape forming member D1 and the second illumination shape forming member D2 or the first polarizing member 4 and second polarizing member 6 as the first illumination forming member and the second illumination forming member are located immediately above the reticles R1, R, but the first illumination shape forming member D1 and second illumination shape forming member D2 or the first polarizing member 4 and second polarizing member 6 may be located on the reticles R1, R2. In this case, the first illumination shape forming member D1 and second illumination shape forming member D2 or the first polarizing member 4 and second polarizing member 6 may be formed on a face (the face on the illumination entrance side) different from the face where the patterns are formed on the substrates of the reticles R1, R2.

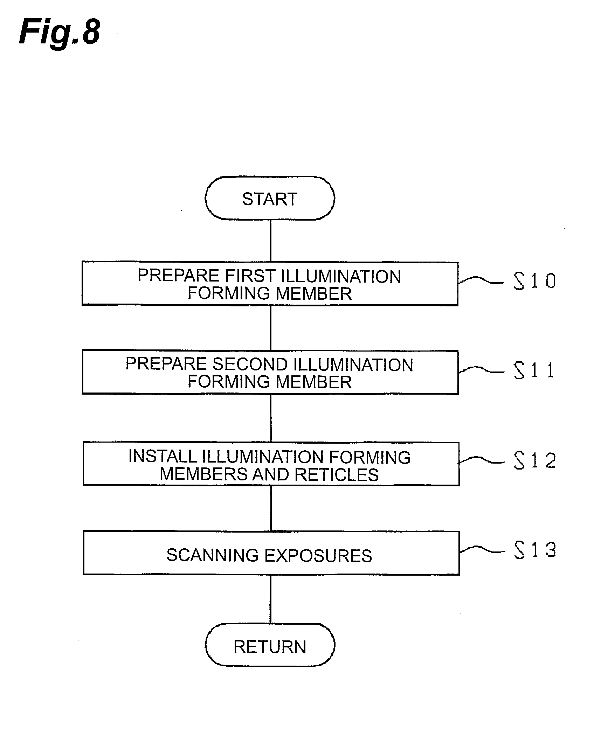

Next, an exposure method using the exposure apparatus according to an embodiment will be described with reference to the flowchart shown in Fig. 8. The exposure method of this embodiment will be described using an example of double exposures to transfer the first pattern formed on the reticle R1, in a superimposed manner on the wafer W on which the second pattern formed on the reticle R2 has been transferred.

The first step is to prepare the first illumination shape forming member D1 or the first polarizing member 4 for formation of the illumination light according to the illumination condition for illumination of the first pattern formed on the reticle R1, as the first illumination forming member (step S10, first-illumination-forming-member preparing step).

The next step is to prepare the second illumination shape forming member D2 or second polarizing member 6 for formation of the illumination light according to the illumination condition for illumination of the second pattern formed on the reticle R2, as the second illumination forming member (step S11, second-illumination-forming-member preparing step).

The subsequent step is to carry the reticle R1, the reticle R2, the first illumination shape forming member D 1 or first polarizing member 4, and the second illumination shape forming member D2 or second polarizing member 6 into the exposure apparatus of the embodiment and install them (step S12). Specifically, the reticle R1 and the reticle R2 are mounted so as to be approximately adjacent to each other along the X-direction (scanning direction) on the reticle stage RST. The first illumination shape forming member D1 or first polarizing member 4 and the second illumination shape forming member D2 or second polarizing member 6 are arranged as approximately adjacent to each other along the X-direction (scanning direction) while being held by the holding member 2. Namely, the first illumination shape forming member D1 or first polarizing member 4 is disposed in the optical path of the illumination light illuminating the reticle R1 and the second illumination shape forming member D2 or second polarizing member 6 is disposed in the optical path of the illumination light illuminating the reticle R2.

Next, the first pattern illuminated with the illumination light having passed through the first illumination shape forming member D1 or first polarizing member 4 is transferred into a first shot area on the wafer W to effect an exposure thereof, while scanning the reticle stage RST and the wafer stage WST (therefore, the reticle R1 and the wafer W), and the first illumination shape forming member D1 or first polarizing member 4 in the scanning direction (X-direction) with respect to the illumination optical system IL and the projection optical system PL. Furthermore, the second pattern illuminated with the illumination light having passed through the second illumination shape forming member D2 or second polarizing member 6 is transferred into a second shot area adjacent to the first shot area on the wafer W to effect an exposure thereof, while scanning the reticle stage RST and the wafer stage WST (therefore, the reticle R2 and the wafer W), and the second illumination shape forming member D2 or second polarizing member 6 in the scanning direction (X-direction) with respect to the illumination optical system IL and the projection optical system PL (step S13). Namely, by scanning the first illumination shape forming member D1 or first polarizing member 4 and the second illumination shape forming member D2 or second polarizing member 6 in synchronism with the reticle R1 and the reticle R2, the first pattern is transferred into the first shot area and the second pattern is consecutively transferred into the second shot area to effect the exposures thereof.

Then the wafer stage WST is moved by a length of one shot area in the scanning direction (X-direction), the first pattern is transferred into the second shot area on the wafer W to effect an exposure thereof, and the second pattern is transferred into a third shot area adjacent to the second shot area on the wafer W to effect an exposure thereof. In this manner, the exposures of the first pattern and the second pattern are effected in a superimposed state in the second shot area. The exposures are sequentially carried out with the first pattern and the second pattern in the superimposed state as described above. The wafer W after the transfer exposures of the first pattern and the second pattern in the superimposed state is transported from the exposure apparatus to a development device to be developed in the development device (development step).

Since the exposure method of this embodiment permits the instant switching into the illumination light suitable for each pattern and the illumination with the illumination light suitable for each pattern, high imaging performance is achieved in each pattern and exposures are carried out at high throughput.

The exposure method of this embodiment was described using the example of double exposures, but the present invention is also applicable to any exposure other than the double exposures.

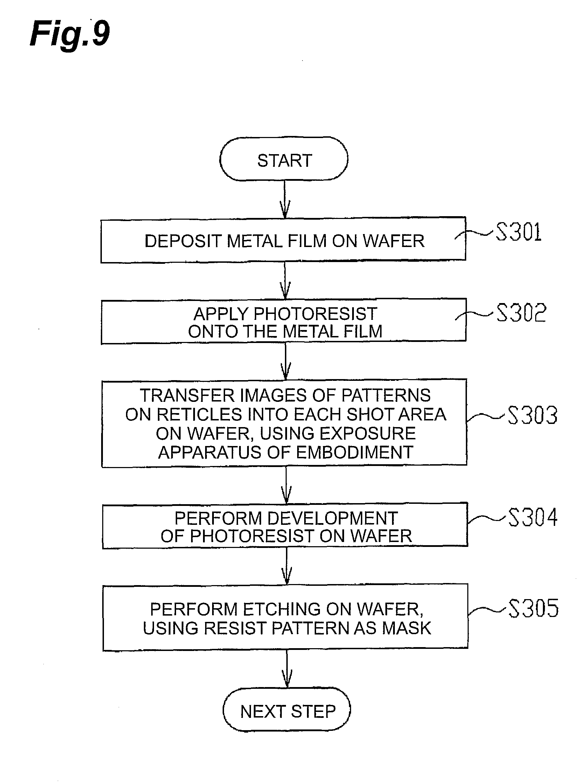

The exposure apparatus of the above-described embodiments can be used to manufacture micro devices (semiconductor devices, imaging devices, liquid-crystal display devices, thin-film magnetic heads, etc.) by exposure of a predetermined pattern on a photosensitive substrate (wafer) through the use of the projection optical system (exposure step). The following will describe an example of a method for manufacturing semiconductor devices as micro devices by forming predetermined circuit patterns on a wafer or the like as a photosensitive substrate by means of the exposure apparatus of the above-described embodiments, with reference to the flowchart of Fig. 9.

The first step S301 in Fig. 9 is to deposit a metal film on a wafer. The next step S302 is to apply a photoresist onto the metal film on the wafer. The subsequent step S303 is to use the exposure apparatus of the above embodiment to sequentially perform superimposed exposures of images of patterns on masks in each shot area on the wafer through the projection optical system. The subsequent step S304 is to perform development of the photoresist on the wafer and the next step S305 is to perform etching using the resist pattern as a mask on the wafer, and thereby to form a circuit pattern corresponding to a predetermined pattern in each shot area on the wafer.

Thereafter, devices such as semiconductor devices are manufactured by performing steps including formation of circuit patterns in upper layers and cutting the wafer into devices. Since the above-described semiconductor device manufacturing method includes execution of the exposure process with the exposure apparatus of the embodiment, it permits the manufacture of highly-accurate semiconductor devices at high throughput. The steps S301-S305 are arranged to perform the respective steps of deposition of metal on the wafer, application of the resist onto the metal film, exposure, development, and etching, but it is needless to mention that the process may be modified as follows: prior to these steps, an oxide film of silicon is formed on the wafer, a resist is then applied onto the silicon oxide film, and thereafter the steps of exposure, development, and etching are carried out.

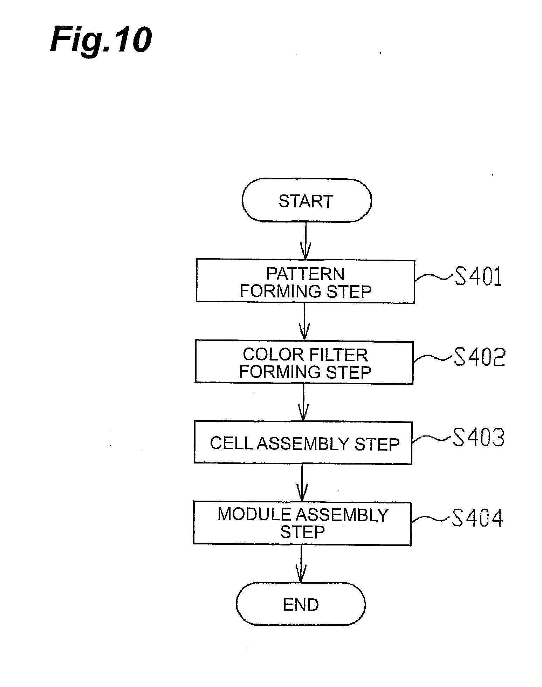

The exposure apparatus of the embodiments can also be used to manufacture a liquid-crystal display device as a micro device by forming predetermined patterns (circuit pattern, electrode pattern, etc.) on plates (glass substrates). An example of a method in this case will be described below with reference to the flowchart of Fig. 10. In Fig. 10, a pattern forming step S401 is to execute the so-called photolithography process of effecting transfer exposures of patterns on masks onto a photosensitive substrate (a glass substrate coated with a resist or the like) by means of the exposure apparatus of the above embodiment. This photolithography process results in forming a predetermined pattern including a large number of electrodes and others on the photosensitive substrate. Thereafter, the exposed substrate is processed through each of steps including a development step, an etching step, a resist removing step, etc. whereby the predetermined pattern is formed on the substrate, followed by the next color filter forming step S402.

The next color filter forming step S402 is to form a color filter in which a large number of sets of three dots corresponding to R (Red), G (Green), and B (Blue) are arrayed in a matrix pattern or in which sets of filters of three stripes of R, G, and B are arrayed in the horizontal scan line direction. After the color filter forming step S402, a cell assembling step S403 is executed. The cell assembling step S403 is to assemble a liquid crystal panel (liquid crystal cell) using the substrate with the predetermined pattern obtained in the pattern forming step S401, the color filter obtained in the color filter forming step S402, and others. In the cell assembling step S403, the liquid crystal panel (liquid crystal cell) is manufactured, for example, by pouring a liquid crystal into between the substrate with the predetermined pattern obtained in the pattern forming step S401 and the color filter obtained in the color filter forming step S402.

The subsequent module assembling step S404 is to attach various components such as electric circuits and backlights for display operation of the assembled liquid crystal panel (liquid crystal cell) to complete the liquid-crystal display device. Since the above-described manufacturing method of the liquid-crystal display device includes execution of the exposure process with the exposure apparatus of the embodiment, it permits the manufacture of highly-accurate liquid-crystal display device at high throughput.

Since the exposure method of the present invention is arranged to scan the first illumination forming member and the second illumination forming member in synchronism with the first pattern and the second pattern, the exposure of the first pattern is effected in the first pattern transfer region with the desired illumination light formed by the first illumination forming member and the transfer exposure of the second pattern is consecutively effected in the second pattern transfer region on the substrate with the desired illumination light formed by the second illumination forming member. Therefore, the illumination light is instantly switched from the illumination light suitable for the first pattern into the illumination light suitable for the second pattern, whereby the throughput is improved.

Since the exposure apparatus of the present invention is arranged to scan the first illumination forming member and the second illumination forming member in synchronism with the first pattern and the second pattern, the exposures of the first pattern is effected in the first pattern transfer region on the substrate with the desired illumination light formed by the first illumination forming member and the transfer exposure of the second pattern is consecutively effected in the second pattern transfer region on the substrate with the desired illumination light formed by the second illumination forming member. Therefore, the illumination light is instantly switched from the illumination light suitable for the first pattern into the illumination light suitable for the second pattern, whereby the throughput is improved.

Since the device manufacturing method of the present invention is arranged to perform the exposure of the predetermined pattern or the exposure of the first pattern and the second pattern by use of the exposure method of the present invention or the exposure apparatus of the present invention, highly-accurate devices can be manufactured at high throughput.

It should be noted that the embodiments explained above were described for easier understanding of the present invention but not for restricting the present invention. Therefore, each of the elements disclosed in the embodiments is intended to embrace all design changes and equivalents belonging to the technical scope of the present invention.

The disclosure in the present specification is associated with the subject matter included in the Japanese Patent Application No. 2006-180623 filed on June 30, 2006, and the disclosure thereof is explicitly incorporated herein by reference in its entirety.

### Industrial Applicability

The present invention is suitably applicable to the exposure method used in the lithography process for manufacturing the semiconductor devices, liquid-crystal display devices, thin-film magnetic heads, and so on, the exposure apparatus using the exposure method, and the device manufacturing method using the exposure method or the exposure apparatus.

## Claims

1. An exposure method for guiding illumination light having passed through a first pattern formed in a first pattern formation region and a second pattern formed in a second pattern formation region different from the first pattern formation region, to a substrate to transfer the first pattern and the second pattern onto the substrate, the exposure method comprising:
a first-illumination-forming-member preparing step of preparing a first illumination forming member for forming illumination light according to an illumination condition for illuminating the first pattern;
a second-illumination-forming-member preparing step of preparing a second illumination forming member for forming illumination light according to an illumination condition for illuminating the second pattern;
a pattern scanning step of scanning the first pattern and the second pattern, and the substrate in a scanning direction with respect to the illumination light;
an illumination-forming-member scanning step of scanning the first illumination forming member and the second illumination forming member in synchronism with the first pattern and the second pattern; and
an exposure step of effecting an exposure of the first pattern in a first pattern transfer region on the substrate and effecting an exposure of the second pattern in a second pattern transfer region on the substrate;
wherein the exposure step comprises consecutively carrying out the exposure of the first pattern and the exposure of the second pattern.

2. The exposure method according to claim 1, wherein the first pattern formation region and the second pattern formation region are arranged so as to be substantially adjacent to each other along the scanning direction,
the exposure method further comprising a second exposure step of effecting an exposure of the first pattern in a superimposed state in the second pattern transfer region in which the second pattern has been transferred.

3. The exposure method according to claim 1 or claim 2, wherein the first pattern formation region and the second pattern formation region are formed on a single original plate.

4. The exposure method according to claim 1 or claim 2, wherein the first pattern formation region is formed on a first original plate, and
wherein the second pattern formation region is formed on a second original plate different from the first original plate.

5. The exposure method according to any one of claims 1 to 4, wherein the first-illumination-forming-member preparing step comprises preparing a first illumination shape forming member for making an angle distribution of the illumination light traveling toward the first pattern, into a first angle distribution, and
wherein the second-illumination-forming-member preparing step comprises preparing a second illumination shape forming member for making an angle distribution of the illumination light traveling toward the second pattern, into a second angle distribution.

6. The exposure method according to claim 5, wherein the first illumination shape forming member and the second illumination shape forming member diffract the illumination light incident thereto.

7. The exposure method according to any one of claims 1 to 5, wherein the first-illumination-forming-member preparing step comprises preparing a first polarizing member for making a polarization state distribution of the illumination light traveling toward the first pattern, into a first polarization state distribution, and
wherein the second-illumination-forming-member preparing step comprises preparing a second polarizing member for making a polarization state distribution of the illumination light traveling toward the second pattern, into a second polarization state distribution.

8. An illumination angle distribution changing member which can be arranged near a photomask on which a pattern to be transferred onto a substrate is formed, and which changes an angle distribution of illumination light traveling toward the photomask,
the illumination angle distribution changing member comprising a polarizing member for setting a polarization state of the illumination light traveling toward the photomask, to a predetermined polarization state.

9. The illumination angle distribution changing member according to claim 8, wherein the polarizing member comprises a polarizer transmitting light polarized in a predetermined polarization direction.

10. The illumination angle distribution changing member according to claim 8 or 9, comprising a diffractive pattern formed on a substrate optically transparent for the illumination light, and changing an angle distribution of the illumination light traveling toward the photomask.

11. The illumination angle distribution changing member
wherein the polarizing member is provided on a face different from a face on the optically transparent substrate on which the pattern of the photomask is formed.

12. The illumination angle distribution changing member according to any one of claims 8 to 11, which is used with the photomask comprising a first pattern formed in a first pattern formation region and a second pattern formed in a second pattern formation region different from the first pattern formation region,
wherein the polarizing member comprises a first polarizing member for making a polarization state of the illumination light traveling toward the first pattern, into a first polarization state; and a second polarizing member for making a polarization state of the illumination light traveling toward the second pattern, into a second polarization state.

13. The illumination angle distribution changing member according to claim 12, wherein the photomask comprises a first photomask comprising the first pattern, and a second photomask comprising the second pattern.

14. An exposure apparatus for guiding illumination light having passed through a first pattern formed in a first pattern formation region and a second pattern formed in a second pattern formation region different from the first pattern formation region, to a substrate to transfer the first pattern and the second pattern onto the substrate, the exposure apparatus comprising:
a first illumination forming member arranged in an optical path of the illumination light traveling toward the first pattern and for forming the illumination light according to an illumination condition for illuminating the first pattern; and
a second illumination forming member arranged in an optical path of the illumination light traveling toward the second pattern and for forming the illumination light according to an illumination condition for illuminating the second pattern;
wherein the first pattern and the second pattern, and the substrate are scanned in a scanning direction with respect to the illumination light to consecutively transfer the first pattern and the second pattern onto the substrate to effect exposures thereof, and
wherein the first illumination forming member and the second illumination forming member are scanned in synchronism with the first pattern and the second pattern.

15. The exposure apparatus according to claim 14, wherein the first pattern formation region and the second pattern formation region are arranged so as to be substantially adjacent to each other along the scanning direction,
wherein a first pattern transfer region on the substrate is exposed with the first pattern and a second pattern transfer region on the substrate is exposed with the second pattern, and
wherein an exposure of the first pattern is effected in a superimposed state in the second pattern transfer region in which the second pattern has been transferred.

16. The exposure apparatus according to claim 14 or claim 15, further comprising an original plate stage holding an original plate on which the first pattern formation region and the second pattern formation region are formed, so as to be movable along the scanning direction.

17. The exposure apparatus according to claim 14 or claim 15,
wherein the first pattern formation region is formed on a first original plate and the second pattern formation region is formed on a second original plate different from the first original plate,
the exposure apparatus further comprising an original plate stage holding the first original plate and the second original plate so as to be movable along the scanning direction.

18. The exposure apparatus according to any one of claims 14 to 17, wherein the first illumination forming member comprises a first illumination shape forming member for making an angle distribution of the illumination light traveling toward the first pattern, into a first angle distribution, and
wherein the second illumination forming member comprises a second illumination shape forming member for making an angle distribution of the illumination light traveling toward the second pattern, into a second angle distribution.

19. The exposure apparatus according to claim 18, wherein the first illumination shape forming member and the second illumination shape forming member comprise a diffractive surface for diffracting the illumination light incident thereto.

20. The exposure apparatus according to any one of claims 14 to 18, wherein the first illumination forming member comprises a first polarizing member for making a polarization state distribution of the illumination light traveling toward the first pattern, into a first polarization state, and
wherein the second illumination forming member comprises a second polarizing member for making a polarization state distribution of the illumination light traveling toward the second pattern, into a second polarization state.

21. A device manufacturing method comprising:
an exposure step of effecting an exposure of a predetermined pattern on a substrate, using an exposure apparatus for performing the exposure by the exposure method as set forth in any one of claims 1 to 7, or using the exposure apparatus as set forth in any one of claims 14 to 20; and
a development step of developing the substrate exposed in the exposure step.

22. A device manufacturing method comprising:
an exposure step of effecting exposures of a first pattern and a second pattern in a superimposed state on a substrate, using an exposure apparatus for performing the exposures by the exposure method as set forth in any one of claims 1 to 7, or using the exposure apparatus as set forth in any one of claims 14 to 20; and
a development step of developing the substrate exposed in the exposure step.
